Europäisches Patentamt

European Patent Office

Office européen des brevets

(11) Veröffentlichungsnummer: **0 262 481**
**A2**

(19)

(12) # EUROPÄISCHE PATENTANMELDUNG

(21) Anmeldenummer: 87113206.4

(22) Anmeldetag: 09.09.87

(51) Int. Cl.⁴: **H03L 7/08** , **H03L 7/14**

(30) Priorität: 30.09.86 DE 3633189

(43) Veröffentlichungstag der Anmeldung:
**06.04.88 Patentblatt 88/14**

(84) Benannte Vertragsstaaten:
**AT BE DE FR GB IT NL SE**

(71) Anmelder: **Siemens Aktiengesellschaft Berlin
und München
Wittelsbacherplatz 2
D-8000 München 2(DE)**

(72) Erfinder: **Geissler, Friedrich, Dipl.-Ing.
Siemensallee 84
D-8000 München 70(DE)**
Erfinder: **Zwack, Eduard, Dipl.-Ing.(FH)
Lochhauserstrasse 86
D-8039 Puchheim(DE)**
Erfinder: **Heitmann, Jürgen, Dr.-Ing.
Bauweberstrasse 34
D-8000 München 71(DE)**

(54) **Schaltungsanordnung zur Erzeugung eines zu einer zugeführten Referenzfrequenz frequenzsynchronen Taktsignals.**

(57) Die Erfindung betrifft eine Schaltungsanordnung zur Erzeugung eines zu einer Referenzfrequenz frequenzsynchronen Taktsignals.

Die Schaltungsanordnung enthält neben einer ersten Phasenvergleichseinrichtung (PA), einer Integrationseinrichtung (I), einem ersten Filter (F1) und einem spannungsgesteuerten Oszillator (VCO) relativ geringer Stabilität mit weitem Ziehbereich einen Frequenzgenerator (FNG) hoher Stabilität mit engem Ziehbereich , eine zweite Phasenvergleichseinrichtung (PB), ein zweites und drittes Filter (F2, F3). Der ersten Phasenvergleichseinrichtung (PA) werden die Referenzfrequenz ($f_R$) und das vom Oszillator (VCO) abgegebene Taktsignal ($f_A$) zugeführt; der zweiten Phasenvergleichseinrichtung (PB) werden das Taktsignal ($f_A$) und die vom Frequenzgenerator (FNG) erzeugte Normalfrequenz ($f_N$) zugeführt.

Bei Ausfall der Referenzfrequenz ($f_R$) oder bei Überschreiten vorgegebener Phasendifferenzwerte wird der durch PB, F2, F3 und VCO gebildeten Regelkreis geschlossen.

FIG 1

## Schaltungsanordnung zur Erzeugung eines zu einer Referenzfrequenz frequenzsynchronen Taktsignals

Die Erfindung betrifft eine Schaltungsanordnung zur Erzeugung eines zu einer zugeführten Referenzfrequenz frequenzsynchronen Taktsignals, mit einem eine externe Referenzfrequenz aufnehmenden Referenzfrequenzempfangsteil, das auf einen ersten Eingang einer ersten Phasenvergleichseinrichtung führt, wobei die erste Phasenvergleichseinrichtung über eine Integrationseinrichtung mit einem ersten Filter und dieses mit einem nachgeschalteten spannungsgesteuerten Oszillator verbindbar ist, der das frequenzsynchrone Taktsignal an den Ausgang der Schaltungsanordnung als auch an einen zweiten Eingang der ersten Phasenvergleichseinrichtung abgibt.

Bei bestimmten übertragungstechnischen Einrichtungen sind Taktsignale in Abhängigkeit einer zugeführten Referenzfrequenz zu erzeugen. Die Frequenz der Taktsignale ist dabei gleich der Referenzfrequenz oder aber die Taktsignalfrequenz steht in einem anderen festen mathematischen Verhältnis zur Referenzfrequenz. Störungen der Referenzfrequenz, die auf der Übertragungsstrecke beispielsweise aufgrund von Temperatureinflüssen oder durch elektromagnetische Einflüsse auftreten, sollen das zu erzeugende Taktsignal nur in einem möglichst geringem Maß beeinflussen.

Zur Erzeugung eines zu einer Referenzfrequenz frequenzsynchronen Taktsignals und der Unterdrückung von Störungen in der Referenzfrequenz werden üblicherweise Phasenregelkreise mit einem Oszillator verwendet. Dabei ist der Ziehbereich der Schaltungsanordnung zur Erzeugung des Taktsignals auf den Ziehbereich des im Phasenregelkreis verwendeten Oszillators begrenzt. Bei an sich gewünschten hochstabilen Oszillatoren ist der Ziehbereich sehr klein; er ist üblicherweise nur etwas größer als die eigene Ungenauigkeit.

Bekannt sind auch Schaltungsanordnungen mit einem weniger stabilen, aber weit ziehbaren Oszillator und einem hochstabilen Oszillator. Bei Ausfall der Referenzfrequenz erfolgt eine Umschaltung von dem weniger stabilen Oszillator mit weitem Ziehbereich auf den hochstabilen Oszillator mit kleinem Ziehbereich. Damit sind diese Schaltungsanordnungen auf Anwendungsfälle beschränkt, in denen sich die Referenzfrequenz nur in einem kleinen Schwankungsbereich ändert. Durch die Umschaltung von dem weniger stabilen auf den hochstabilen Oszillator erfolgt ein Frequenzsprung, der die Frequenzsynchronität zwischen der zuletzt zugeführten Referenzfrequenz und dem neuen Taktsignal aufhebt.

Der Erfindung liegt die Aufgabe zugrunde, eine Schaltungsanordnung zur Erzeugung eines zu einer Referenzfrequenz frequenzsynchronen Taktsignals zu schaffen, die bei Änderungen der Referenzfrequenz innerhalb eines vorgegebenen Bereichs die Referenzfrequenz nicht beeinflußt, jedoch beim Ausfall der Referenzfrequenz ein mit der zuletzt zugeführten Referenzfrequenz frequenzsynchrones Taktsignal erzeugt.

Die Lösung dieser Aufgabe erfolgt mit den im kennzeichnenden Teil des Patentanspruchs 1 genannten Merkmalen.

Die Schaltungsanordnung gemäß der Erfindung ist mit dem Vorteil verbunden, daß sie auch frequenzsynchrone Taktsignale für Referenzfrequenzen erzeugt, die sich in einem relativ großen Schwankungsbereich um eine vorgegebene Nennfrequenz ändern. Zugleich zeichnet sich die Schaltungsanordnung durch den Vorteil aus, daß das frequenzsynchrone Taktsignal eine hohe Stabilität erhält.

Ausführungsformen der Erfindung werden nun anhand der Zeichnungen in einem zum Verständnis erforderlichen Umfang erläutert. Es zeigt

FIG 1 eine erste Schaltungsanordnung gemäß der Erfindung und

FIG 2 eine zweite Schaltungsanordnung gemäß der Erfindung.

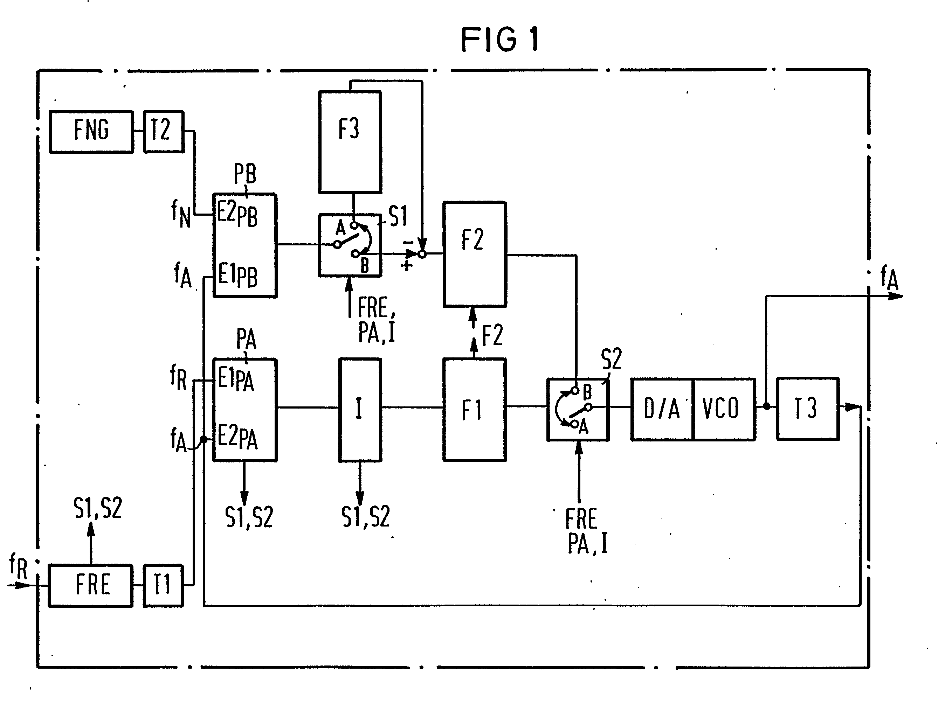

Die in FIG 1 dargestellte erste Schaltungsanordnung weist eingangsseitig einen Referenzfrequenzempfangsteil FRE auf. Dem Referenzfrequenzempfangsteil FRE wird ein externes Referenzfrequenzsignal zugeführt, das kurzzeitig Störungen darstellende Frequenzabweichungen aufweist. Die Schaltungsanordnung weist eingangsseitig ferner einen Normalfrequenzgenerator FNG auf. Das Referenzfrequenzempfangsteil FRE und der Normalfrequenzgenerator FNG führen jeweils auf einen ersten Eingang $E1_{PA}$ einer ersten Phasenvergleichseinrichtung PA beziehungsweise $E1_{PB}$ einer zweiten Phasenvergleichseinrichtung PB. Die erste Phasenvergleichseinrichtung PA ist über ein Integrierglied I mit einem ersten Filter F1 und die zweite Phasenvergleichseinrichtung PB über ein erstes Schaltelement S1 mit einem zweiten Filter F2 verbunden. Das erste Schaltelement S1 ist beispielsweise, wie noch erläutert wird, von dem Referenzfrequenzempfangsteil FRE steuerbar. Dem ersten und zweiten Filter F1 und F2 ist ein zweites, ebenfalls von dem Referenzfrequenzempfangsteil FRE steuerbares Schaltelement S2 nachgeschaltet, das ausgangsseitig mit einem spannungsgesteuerten Oszillator VCO verbunden ist. Der Oszillator VCO, dem gegebenenfalls eine Digital-/Analogwandlungseinrichtung D/A vorgeschaltet ist, erzeugt das Taktsignal beziehungsweise die Ausgangsfrequenz $f_A$, die an den Ausgang der erfindungsgemäßen Schaltungsanordnung zur Weiterverarbeitung abgegeben wird. Er ist ausgangsseitig mit dem jeweils zweiten Eingang $E2_{PA}$, $E2_{PB}$ der ersten und zweiten Phasenvergleichseinrichtung PA und PB verbunden.

Der Oszillator VCO weist eine nur geringe Stabilität und einen weiten Ziehbereich auf, der mindestens dem Schwankungsbereich der Referenzfrequenz $f_R$ um ihren Nennwert entspricht.

Dem Normalfrequenzgenerator FNG, dem Referenzfrequenzempfangsteil FRE und dem spannungsgesteuerten Oszillator VCO können Anordnungen zur Realisierung eines beliebigen Teilungsfaktors der jeweils zugeführten Frequenz nachgeschaltet sein. Bei dem in FIG 1 dargestellten Ausführungsbeispiel sind Teilungsanordnungen T1, T2 und T3 am Ausgang der Einrichtungen FRE, FNG und VCO vorgesehen.

Zwischen dem ersten Schaltelement S1 und dem zweiten Filter F2 sind ein drittes Filter F3 und ein Subtrahierglied angeordnet.

Die externe Referenzfrequenz $f_R$ wird dem Referenzfrequenzempfangsteil FRE zugeführt, das die Referenzfrequenz $f_R$ nach einer gegebenenfalls notwenigen Anpassung für die weitere Verarbeitung an den ersten Eingang E1 $_{PA}$ der ersten Phasenvergleichseinrichtung PA durchschaltet. Ihrem zweiten Eingang $E2_{PA}$ wird das durch die Schaltungsanordnung gebildete Ausgangssignal $f_A$ zugeführt, das bei ungestörter Referenzfrequenz $f_R$ gleich dieser Frequenz $f_R$ ist und das im Falle einer Störung in Abhängigkeit von der gestörten Referenzfrequenz $f_R^!$ gebildet wird.

Die erste Phasenvergleichseinrichtung PA ermittelt für bestimmte, regelmäßig gleiche Abtastzeiträume $\Delta\phi$ die Phasendifferenz zwischen beiden Eingangssignalen $f_R$ und $f_A$. Die Einrichtung PA speichert zunächst den Wert einer ersten Phasendifferenz, für einen ersten Zeitpunkt $t_1$ und vergleicht diesen ersten Wert mit dem Wert einer zweiten Phasendifferenz, die zu einem, dem ersten Zeitpunkt $t_1$ nachfolgenden, zweiten Zeitpunkt $t_2$ an ihren Eingängen auftritt. Die Differenz beider Werte bezeichnet die Änderung der Phasendifferenz im Zeitraum zwischen $t_1$ und $t_2$.

Der Differenzwert wird der nachgeschalteten Integrationseinrichtung I zugeführt. Sie bildet den Phasendifferenzwert durch Integration zurück. Dieser Weg der Differenzierung und nachfolgenden Integration wird gewählt, um die Differenzbildung - schaltungstechnisch in einfacher Weise zu realisieren. Darüberhinaus lassen sich auf diesem Weg Phasendifferenzen von mehr als 360° beziehungsweise mehr als einer Periodendauer T erkennen.

Das Filter F1 bildet in Abhängigkeit der zugeführten Phasendifferenzwerte Stellgrößen für die Ansteuerung des spannungsgesteuerten Oszillators VCO.

Liegt im eingeschwungenen Zustand der Anordnung keine Phasendifferenz an den Eingängen der ersten Phasenvergleichseinrichtung PA vor, ist also die der Schaltung extern zugeführte Referenzfrequenz $f_R$ gleich der schaltungsintern gebildeten Ausgangsfrequenz $f_A$, bildet das Filter F1 eine Folge erster Stellgrößen für den Oszillator VCO, die konstant gehalten werden.

Das zwischen dem ersten Filter F1 und dem Oszillator VCO angeordnete zweite Schaltelement S2 kann wie bereits erwähnt durch das Referenzfrequenzempfangsteil FRE gesteuert werden. Bei Ausfall der Referenzfrequenz $f_R$ steuert das Empfangsteil FRE das Schaltelement S2 von der Stellung A in die Stellung B. Diese Umschaltung kann auch von der ersten Phasenvergleichseinrichtung PA bei Überschreiten eines vorgegebenen Schwellwerts

$$\frac{\Delta\varphi_S}{\Delta t}$$

oder von der Integrationseinrichtung I bei Überschreiten eines vorgegebenen Schwellwerts $\Delta\phi_S$ bewirkt werden. Das erste Schaltelement S1 ist wie S2 vom Referenzfrequenzempfangsteil FRE, von der ersten Phasenvergleichseinrichtung PA oder von der Integrationseinrichtung I steuerbar. Beide Schaltelemente S1 und S2 weisen zwei Schaltstellungen A und B auf. Die beiden Schaltelemente S1 und S2 befinden sich zu jedem Zeitpunkt in der gleichen Stellung A oder B.

Bei Auftreten von Phasendifferenzwerten am Eingang des Filters F1, die beispielsweise durch auf den Oszillator VCO wirkende Störungen oder durch Störungen darstellende Änderungen der externen Referenzfrequenz $f_R$ verursacht werden, bildet das Filter F1 eine Folge zweiter Stellgrößen für den Oszillator VCO. Diese Stellgrößenfolge ist so ausgebildet, daß der Oszillator VCO im eingeschwungenen Zustand Frequenzen $f_{A1}$, $f_{A2}$, ... erzeugt, die zu einer Phasendifferenz 0 mit der geänderten Referenzfrequenz $f_R^!$ führen.

Das Filter F1 kann beispielsweise als P-, PI- oder PID-Filter ausgebildet sein. Zur Bestimmung des Einschwingverhaltens im Regelkreis, der aus der ersten Phasenvergleichseinrichtung PA, der Integrationseinrichtung I, dem Filter F1, dem Schaltelement S2 (in der Stellung A), gegebenenfalls aus einer Digital-/Analogwandlungseinrichtung D/A sowie dem spannungsgesteuerten Oszillator VCO gebildet wird, werden Filterart und Filterkonstanten in an sich bekannter Weise gewählt.

Soweit die vom Filter F1 abgegebene Stellgröße in digitaler Form gebildet wird, der Oszillator VCO jedoch durch ein Analogsignal anzusteuern ist, wird zwischen beiden Komponenten die Einrichtung D/A angeordnet.

Befinden sich beide Schaltelemente S1 und S2 in der Stellung A (kein Ausfall der Referenzfrequenz $f_R$, beziehungsweise kein Überschreiten der Schwellwerte

$$\frac{\Delta \phi_S}{\Delta T}$$

$\Delta \phi_S$ ), so wird der von der zweiten Phasenvergleichseinrichtung PB ermittelte Phasendifferenzwert an das dritte Filter F3 durchgeschaltet. Dieser Phasendifferenzwert ergibt sich aus dem Vergleich der den beiden Eingängen $E1_{PB}$ und $E2_{PB}$ zugeführten Frequenzen, der intern gebildeten Ausgangsfrequenz $f_A$ und der vom Normalfrequenzgenerator FNG erzeugten Normalfrequenz $f_N$. Die Stabilität des Normalfrequenzgenerators FNG liegt erheblich über der Stabilität des Oszillators VCO.

Das dritte Filter F3 kannn ebenso wie das erste Filter F1 als P-, PI-oder PID-Filter ausgebildet sein. Es bildet aus dem von der zweiten Phasenvergleichseinrichtung PB zugeführten Phasendifferenzwerten abgeleitete Werte. Diese Werte sind ein Maß für die Differenz zwischen der intern von Oszillator VCO gebildeten Ausgangsfrequenz $f_A$ und der vom Normalfrequenzgenerator FNG gebildeten Normalfrequenz $f_N$. Ist diese Differenz gleich 0, so ist auch der abgeleitete Wert 0.

Die Filtercharakteristik des dritten Filters F3 wird in Abhängigkeit der Filtercharakteristik des ersten Filters F1 bestimmt: Beispielsweise liegt die Zeitkonstante von F3 erheblich über der Zeitkonstante des duch F1 mitgebildeten Regelkreises. Ein typischer Wert für die Zeitkonstante dieses Regelkreises liegt im Minutenbereich. Die Zeitkonstante für das Filter F3 liegt um einen Faktor größer 1, insbesondere bis zum Faktor 10 über der Zeitkonstante des durch F1 mitgebildeten Regelkreises.

In der Schalterstellung A ist die weitere Behandlung der Ausgangswerte des Filters F3 ohne Bedeutung, weil das nachgeschaltete zweite Filter F2 nicht an den Oszillator VCO angekoppelt ist. Bei Umschaltung in die Schalterstellung B, also bei Ausfall der Referenzfrequenz $f_R$ beziehungsweise bei Überschreiten der Schwellwerte und

$$\frac{\Delta \phi}{\Delta t}$$

und $\Delta \phi_S$, wird das zweite Filter F2 an den Oszillator VCO angekoppelt. Gleichzeitig wird dem Filter F2 über das vorgeschaltete Subtrahierglied ein Differenzwert zugeführt, der aus dem von der zweiten Phasenvergleichseinrichtung PB gebildeten Phasendifferenzwert und aus dem vom dritten Filter F3 gehaltenen, zuvor in der Schaltstellung A gebildeten Wert besteht.

Das Filter F2 übernimmt in der Schalterstellung B, durch den ein Regelkreis mit PB, F2 und VCO gebildet wird, die Funktion des Filters F1 im ursprünglichen Regelkreis und kann daher wie F1 beschaffen sein. Die vom zweiten Filter F2 gebildete Stellgrößenfolge wird also dem Oszillator VCO zugeführt. Im eingeschwungenen Zustand wird der Differenzwert, der dem Filter F2 zugeführt wird, zu 0 geregelt. Die vom zweiten Filter F2 abgegebene Stellgrößenfolge ist im eingeschwungenen Zustand bei Ausfall der Referenzfrequenz $f_R$ und bei ungestörtem Betrieb des Oszillators VCO konstant.

Die erfindungsgemäße Schaltungsanordnung mit dem hochstabilen Normalfrequenzgenerator FNG, den beiden Phasenvergleichseinrichtungen PA und PB, den Filtern F1, F2 und F3, dem Oszillator VCO mit geringer Stabilität sowie mit den übrigen Komponenten führt dazu, daß die Stabilität des erzeugten Taktsignals beziehungsweise der Ausgangsfrequenz $f_A$ der hochstabilen Normalfrequenz $f_N$ entspricht. Der Wert der Ausgangsfrequenz $f_A$ nach Ausfall der Referenzfrequenz ist dann gleich dem Wert der zuletzt zugeführten Referenzfrequenz $f_R$ beziehungsweise dem durch Filter F3 gebildeten Mittelwert.

Darüber hinaus wird eine Frequenzablage ($f_A$ ungleich $f_N$ ) in der Größenordnung des relativ weiten Ziehbereichs des Oszillators VCO ermöglicht. Eine große Frequenzablage ist notwendig, um bei Ausfall der Referenzfrequenz $f_R$ eine Frequenz $f_A$ abgeben zu können, die gegebenenfalls weit von dem Nominal-oder Nennwert der Referenzfrequenz $f_R$ abliegt.

Zum Zeitpunkt der Umschaltung in die Schalterstellung B enthält das Filter F2 undefinierte Anfangswerte, die ausgangsseitig zu Stellgrößen für den Oszillator VCO führen, die den Einschwingvorgang erheblich verzögern können.

Erfindungsgemäß werden mit der Umschaltung in die Schalterstellung B die aktuellen, der Bildung der Stellgrößen dienenden Zwischenwerten vom Filter F1 in das Filter F2 transferiert. Filter F1 ist zu diesem Zweck, wie in FIG 1 durch von F1 zu F2 weisenden Pfeil angedeutet, mit F1ter F2 verbindbar. Diese Zwischenwerte können im Zeitpunkt der Umschaltung ohne Änderung als Anfangswerte für F2 übernommen werden, wenn beide Filter F1 und F2 identisch aufgebaut sind. Ansonsten sind die transferierten Werte entsprechend umzubilden.

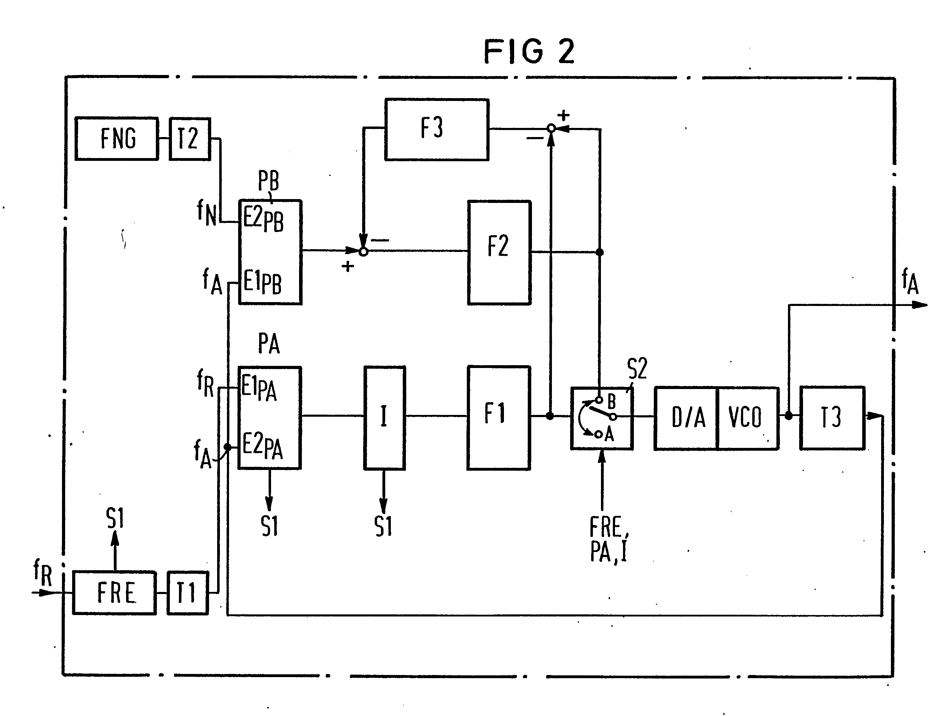

Das Transferieren der Werte von Filter F1 in das Filter F2 erübrigt sich mit der zweiten Schaltungsanordnung gemäß der Erfindung nach FIG 2. In dieser Schaltungsanordnung entfällt gegenüber der Schaltungsanordnung nach FIG 1 die erste Schalteinrichtung S1, so daß die zweite Phasenvergleichseinrichtung PB und das zweite Filter F2 also über das in der Schaltungsanordnung nach FIG 1 vorgesehene erste Subtrahierglied fest miteinander verbunden sind. Ein zweites, am Ausgang des zweiten und ersten Filters F2 und F1 entsprechend FIG 2 angeordnetes Subtrahierglied führt an den Eingang des dritten Filters F3.

Der Eingangswert für das Filter F3 wird aus der Differenz der vom Filter F2 und Filter F1 erzeugten Stellwerte gebildet. Während in der Schaltungsanordnung nach FIG 1 immer nur einer der beiden Regelkreise (1. Kreis = $P_A$, I, F1, VCO; 2. Kreis = $P_B$, F3, F2, VCO) geschlossen war und beim Umschalten vom ersten auf den zweiten Kreis entweder das Transferieren der Werte vom Filter F1 in das Filter F2 notwendig wurde, oder aber unerwünschte Verzögerungen des Einschwingvorgangs entstanden, wird in der Schaltungsanordnung nach FIG 2 im Normalbetrieb zusätzlich zu dem in der FIG 2 unten dargestellen ersten Regelkreis (PA, I, F1, VCO), der identisch mit dem ersten Regelkreis aus FIG 1 ist, der in der FIG 2 oben dargestellte Regelkreis geschlossen, der die Differenz der Stellgrößen des ersten und zweiten Filters F1 und F2 zu 0 regelt. Bei der Schaltungsanordnung nach FIG 2 bildet das zweite Filter F2 während des Normalbetriebs (kein Ausfall der Referenzfrequenz $f_R$, keine Störungen des Oszillators VCO) jeweils aktuelle Werte von Stellgrößen zur Ansteuerung des Oszillators VCO. Diese Stellgrößen werden im Normalbetrieb (Schalterstellung A) jedoch nicht an den VCO durchgeschaltet. Das Filter weist damit beim Umschalten von Stellung A auf Stellung B (Schaltungselement S2) im Störungsfall ohne Unterbrechung unmittelbar die internen Werte eines eingeschwungenen Filters auf und gibt Stellwerte an VCO ab, die zu keinem Frequenzsprung von $f_A$ im Umschaltzeitpunkt führen.

## Ansprüche

1. Schaltungsanordnung zur Erzeugung eines zu einer zugeführten Referenzfrequenz frequenzsynchronen Taktsignals, mit einem eine externe Referenzfrequenz ($f_R$) aufnehmenden Referenzfrequenzempfangsteil (FRE), das auf einen ersten Eingang ($E1_{PA}$) einer ersten Phasenvergleichseinrichtung (PA) führt, wobei die erste Phasenvergleichseinrichtung (PA) über eine Integrationseinrichtung (I) mit einem ersten Filter (F1) und dieses mit einem nachgeschalteten spannungsgesteuerten Oszillator (VCO) verbindbar ist, der das frequenzsynchrone Taktsignal ($f_A$) an den Ausgang der Schaltungsanordnung als auch an einen zweiten Eingang ($E2_{PA}$) der ersten Phasenvergleichseinrichtung (PA) abgibt,

**dadurch gekennzeichnet,** daß die Schaltungsanordnung eine zweite Phasenvergleichseinrichtung (PB) mit einem ersten Eingang ($E1_{PB}$) und einem zweiten, mit dem Ausgang des spannungsgesteuerten Oszillators (VCO) verbundenen Eingang ($E2_{PB}$) aufweist, daß ein hochstabiler Normalfrequenzgenerator (FNG) auf den ersten Eingang ($E1_{PB}$) der zweiten Phasenvergleichseinrichtung (PB) führt, der ein erstes, vom Referenzfrequenzempfangsteils (FRE), der ersten Phasenvergleichseinrichtung (PA) oder der Integrationseinrichtung (I) steuerbares, zwei Ausgänge (A, B) aufweisendes Schaltelement (S1) nachgeschaltet ist, daß das erste Schaltelement (S1) bei Ausfall der Referenzfrequenz ($f_R$) oder bei Überschreiten einer vorgegebenen Phasendifferenz zwischen Referenzfrequenz ($f_R$) und Taktsignal ($f_A$) von der Schaltstellung (A) in die Schaltstellung (B) umschaltet und dabei die zweite Phasenvergleichseinrichtung (PB) mit dem Subtrahend-Eingang eines erstes Subtrahierglieds verbindet, dessen Ausgang in ein zweites Filter (F2) führt, daß zwischen dem ersten Ausgang (A) des ersten Schaltelements (S1) und dem Minuend-Eingang des ersten Subtrahierglieds ein drittes Filter (F3) angeordnet ist, und daß das erste Filter (F1) auf dem ersten Eingang (A) eines zweiten, mit dem ersten Schaltelement (S1) synchrones Schaltelement (S2) führt, dessen zweiter Eingang (B) mit dem Ausgang des zweiten Filters (F2) verbunden ist, und daß der Ausgang des zweiten Schaltelements (S2) mit dem spannungsgesteuerten Oszillators (VCO) verbunden ist.

2. Schaltungsanordnung nach Anspruch 1, **dadurch gekennzeichnet,** daß das erste Filter (F1) in der Weise mit dem zweiten Filter (F2) verbindbar ist, daß bei Ausfall der Referenzfrequenz ($f_R$) oder bei Überschreiten einer vorgegebenen Phasendifferenz zwischen Referenzfrequenz ($f_R$) und Taktsignal ($f_A$) zur Bildung des Ausgangswerts des ersten Filters (F1) gebildete Zwischenwerte in das zweite Filter (F2) übertragen werden.

3. Schaltungsanordnung nach Anspruch 1, **dadurch gekennzeichnet,** daß die zweite Phasenvergleichseinrichtung (PB) unmittelbar mit dem Subtrahend-Eingang des ersten Subtrahierglieds und der Eingang des dritten Filters (F3) mit dem Ausgang eines zweiten Subtrahierglieds verbunden ist, dessen Subtrahend-Eingang mit dem Ausgang des zweiten Filters (F2) und dessen Minuend-Eingang mit dem Ausgang des ersten Filters (F1) verbunden ist.

# FIG 1

0 262 481

# FIG 2

0 262 481